# EUROPEAN PATENT APPLICATION

(11) **EP 4 535 928 A1**
(43) Date of publication of application: **09.04.2025**
(21) Application number: 24202448.7
(22) Date of filing: 25.09.2024
(51) Int. Cl.: H05K 1/02, H05K 3/00

(54) **PRINTED CIRCUIT BOARD, OPTICAL SENSOR, AND IMAGE FORMING APPARATUS**

(30) Priority: 26.09.2023 JP 2023163579; 19.07.2024 JP 2024116126
(71) Applicant: CANON KABUSHIKI KAISHA, Tokyo 146-8501 (JP)
(72) Inventor: TAKAHASHI, Masayoshi, Tokyo, 146-8501 (JP)
(74) Representative: TBK

(57) **Abstract**

A printed circuit board (100) comprises a substrate (102) and an electrically conductive pattern (104). The pattern (104) includes an electrode pad (107a) and a teaching pattern (120a; 120b) that teaches a mountable range of an electronic component and includes a first line (131a; 131b) and a second line (132a; 132b). The electronic component includes a first side surface extending in a first direction. The first line and the second line extend in the first direction. In a second direction, the first side surface is between the first line and the second line. In the first direction, the first line and the second line are each in a position different from that of the first side surface.

## Description

### BACKGROUND OF THE INVENTION

### Field of the Invention

The present disclosure relates to a technique for facilitating mounting of an electronic component onto a printed circuit board, the printed circuit board, an optical sensor, and an image forming apparatus.

### Description of the Related Art

There are various types of electronic components with different arrangements of electrodes or terminals. If electronic components are not mounted in correct positions on a surface of a printed circuit board, the electronic components will not operate correctly. Therefore, thin lines indicating positions at which to arrange electrodes of electronic components are formed by silkscreen printing on a surface of a printed circuit board (Japanese Patent Laid-Open No. 2007-012771). Solder balls, which are ball grid array (BGA)-type electrodes of electronic components, are arranged on back sides of electronic components. Therefore, a confirmation line that allows confirmation of a shift in position between a printed circuit board and an outline of a BGA with the naked eye is printed by silkscreen printing (Japanese Patent Laid-Open No. 2000-133898).

A process for forming lines by silkscreen printing indicating mounting positions of electronic components is different from a process for forming lands (electrode pads) on which electronic components are to be mounted. Therefore, a shift in position of lines formed by silkscreen printing relative to lands tends to be large. As a result, when electronic components are arranged so as to be aligned with the lines formed by silkscreen printing, the electronic components would sometimes not be arranged at correct positions on the printed circuit board.

### SUMMARY OF THE INVENTION

The disclosure provides a printed circuit board as specified in Claims 1-18.

The disclosure provides an optical sensor as specified in Claim19. The disclosure provides an image forming apparatus as specified in Claim 20.

Further features of the present disclosure will become apparent from the following description of exemplary embodiments (with reference to the attached drawings).

### BRIEF DESCRIPTION OF THE DRAWINGS

FIGS. 1A to 1C are diagrams illustrating a printed circuit board.
FIG. 2 is a diagram illustrating markings printed by silkscreen printing on a surface of a printed circuit board.
FIGS. 3A to 3C are diagrams illustrating the printed circuit board.
FIGS. 4A to 4C are diagrams illustrating the printed circuit board.
FIG. 5 is a diagram illustrating the printed circuit board.
FIG. 6 is a diagram illustrating the printed circuit board.
FIGS. 7A to 7C are diagrams illustrating the printed circuit board.
FIGS. 8A to 8C are diagrams illustrating the printed circuit board.
FIG. 9 is a diagram illustrating the printed circuit board.
FIGS. 10A to 10C are diagrams suggesting other shapes of a teaching pattern.
FIG. 11 is a diagram illustrating an optical sensor.
FIG. 12 is a diagram illustrating an image forming apparatus.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

### <Example 1>

### (1) Structure of Printed Circuit Board

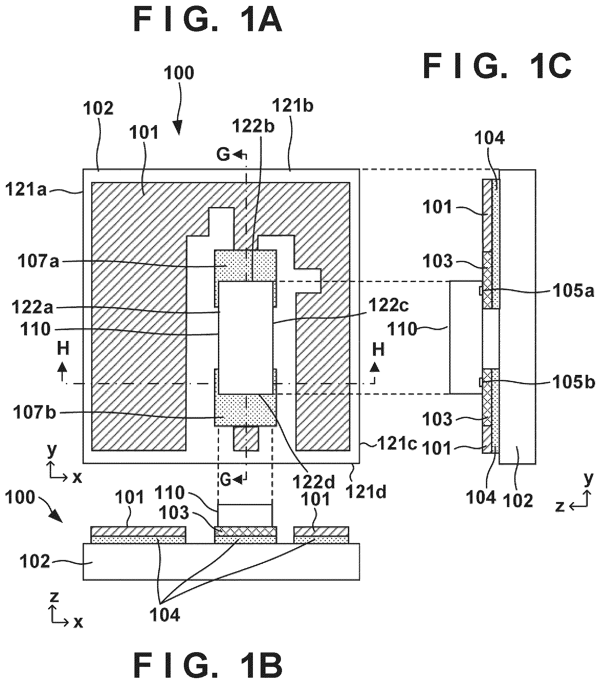

FIG. 1A is a plan view of a printed circuit board 100 according to a first embodiment. FIG. 1B is a cross-sectional view of the printed circuit board 100 along a cutting line H-H. FIG. 1C is a cross-sectional view of the printed circuit board 100 along a cutting line G-G. "z" indicates a height direction of the printed circuit board 100. "x" and "y" indicate directions parallel to a mounting surface of the printed circuit board 100. An electronic component 110 is mounted on the mounting surface of the printed circuit board 100. In the present specification, lowercase letters such as a, b, c, and d may be added to ends of reference numerals. These are added to distinguish between identical or similar elements. Thus, when matters common to identical or similar elements are described, the lowercase letters may be omitted.

The printed circuit board 100 includes an insulating substrate 102, an electrically conductive pattern 104, and a resist 101. The insulating substrate 102 is glass epoxy resin or the like. The electrically conductive pattern 104 is copper foil or the like formed or stacked on the substrate 102. The resist 101 is an insulating layer formed or stacked on the electrically conductive pattern 104. Portions of the electrically conductive pattern 104 that are soldered to electrodes of the electronic component 110 are called electrode pads 107a and 107b. The electrode pads 107a and 107b may be referred to as lands. There is solder 103 between the electronic component 110 and the electrode pads 107a and 107b. Electrodes 105a and 105b of the electronic component 110 and the electrically conductive pattern 104 are connected by the solder 103 and are electrically conductive.

A thickness of the electrically conductive pattern 104 in the z direction is, for example, 35 um. "um" is an abbreviation for micrometer. The electrode pads 107a and 107b are portions of the electrically conductive pattern 104. The resist 101 is an insulating layer provided on an upper layer of the electrically conductive pattern 104 and the printed circuit board 100. A thickness of the resist 101 in the z direction is, for example, 30 um. The electrically conductive pattern 104 is covered by the resist 101, but a shape of the electrically conductive pattern 104 is visible. This is because the resist 101 is translucent.

The substrate 102 includes a first side 121a, a second side 121b, a third side 121c, and a fourth side 121d. The first side 121a and the third side 121c are parallel. The second side 121b and the fourth side 121d are parallel. The first side 121a and the second side 121b are orthogonal. In the specification and the like, ordinal particles such as first and second are only added for descriptive convenience.

The electronic component 110 includes a first side surface 122a, a second side surface 122b, a third side surface 122c, and a fourth side surface 122d. The first side surface 122a and the third side surface 122c are parallel. The second side surface 122b and the fourth side surface 122d are parallel. The first side surface 122a and the second side surface 122b are orthogonal. The first side surface 122a, the second side surface 122b, the third side surface 122c, and the fourth side surface 122d extend in directions along the mounting surface of the printed circuit board 100 and the substrate 102.

### (2) Comparative Example

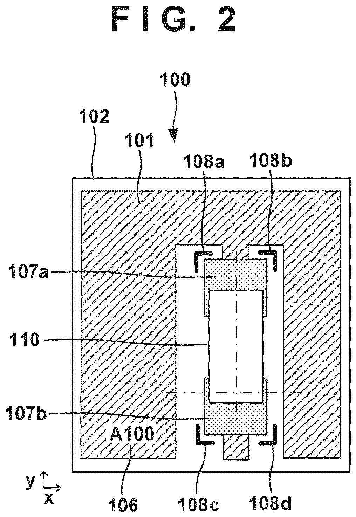

FIG. 2 illustrates a comparative example. Silkscreen text 106 and silkscreen markings 108a to 108d are printed on the resist 101. The silkscreen text 106 and the silkscreen markings 108a to 108d are printed using, for example, non-conductive epoxy ink or the like. A thickness of the silkscreen text 106 in the z direction is, for example, 30 um. A process for printing the silkscreen text 106 and the silkscreen markings 108a to 108d is different from a process for forming the electrically conductive pattern 104.

The silkscreen text 106 indicates a location number (A100 which is a location number of the electronic component 110) of an electrical element. The silkscreen markings 108a to 108d indicate a mountable range of the electronic component 110 on the printed circuit board 100.

The silkscreen markings 108a to 108d have L shapes. If four corners of the electronic component 110 are positioned inside the silkscreen markings 108a to 108d, a mounting position of the electronic component 110 is correct. However, the process for printing the silkscreen markings 108a to 108d is different from the process for forming the electrically conductive pattern 104. Therefore, positions of the silkscreen markings 108a to 108d relative to the electrically conductive pattern 104 vary. As a result, even when the electronic component 110 is arranged inside the silkscreen markings 108a to 108d, the electronic component 110 may be shifted relative to the electrode pads 107a and 107b.

### (3) Markings for Teaching Mounting Position of Electronic Component

### (3-1) Alignment (Positioning) of Electronic Component in y Direction

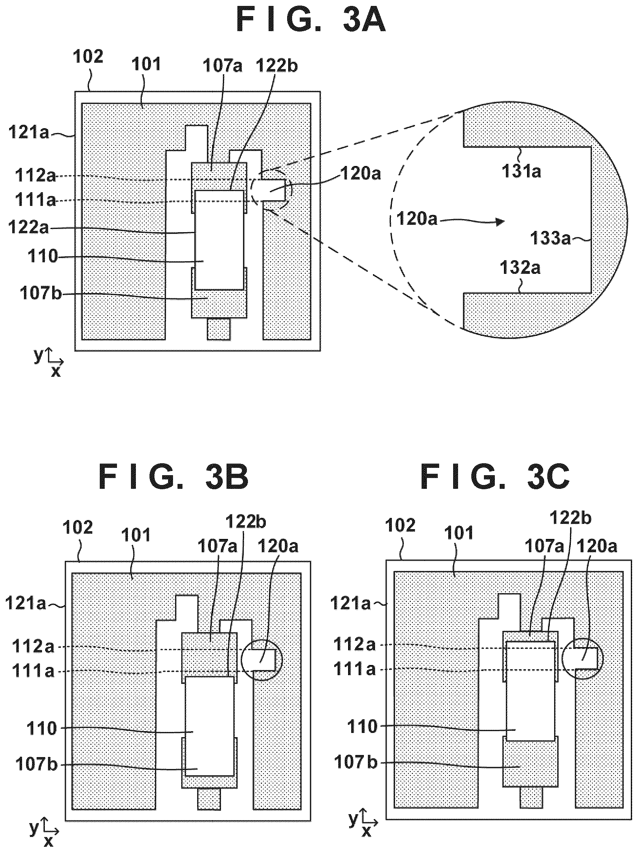

FIGS. 3A to 3C are plan views illustrating a surface of the printed circuit board 100 in which illustration of the resist 101 is omitted. FIG. 3A illustrates an enlarged view of a teaching pattern 120a. The teaching pattern 120a is an electrically conductive pattern formed in the same process as that for the electrically conductive pattern 104. That is, the teaching pattern 120a and the electrode pads 107a and 107b are manufactured in the same process, and so, a positional relationship between the teaching pattern 120a and the electrode pads 107a and 107b is accurate. The teaching pattern 120a has a concave shape constituted by two parallel lines 131a and 132a and a line 133a. The line 133a connects the two lines 131a and 132a. Two imaginary lines 112a and 111a are lines illustrated for descriptive convenience and are imaginary lines obtained by extending each of the two lines 131a and 132a. The two lines 131a and 132a and the two imaginary lines 112a and 111a are parallel to the second side surface 122b, which intersects the first side surface 122a of the electronic component 110.

The two lines 131a and 132a and the two imaginary lines 112a and 111a indicate a mountable range of the electronic component 110 in the y direction. The line 131a and the imaginary line 112a indicate one limit position (upper limit position) in the mountable range of the electronic component 110. The line 132a and the imaginary line 111a indicate the other limit position (lower limit position) in the mountable range of the electronic component 110.

According to FIG. 3A, the second side surface 122b of the electronic component 110 is positioned between the two lines 131a and 132a (two imaginary lines 112a and 111a) constituting the teaching pattern 120a. Therefore, it can be seen that the electronic component 110 is accurately arranged relative to the printed circuit board 100.

According to FIG. 3B, the electronic component 110 is arranged so as to be shifted in a -y direction. The second side surface 122b of the electronic component 110 is not positioned between the two lines 131a and 132a (two imaginary lines 112a and 111a) constituting the teaching pattern 120a. Therefore, it can be seen that the electronic component 110 is not accurately arranged relative to the printed circuit board 100.

According to FIG. 3C, the electronic component 110 is arranged so as to be shifted in a +y direction. The second side surface 122b of the electronic component 110 is not positioned between the two lines 131a and 132a (two imaginary lines 112a and 111a) constituting the teaching pattern 120a. Therefore, it can be seen that the electronic component 110 is not accurately arranged relative to the printed circuit board 100.

### (3-2) Alignment of Electronic Component in x Direction

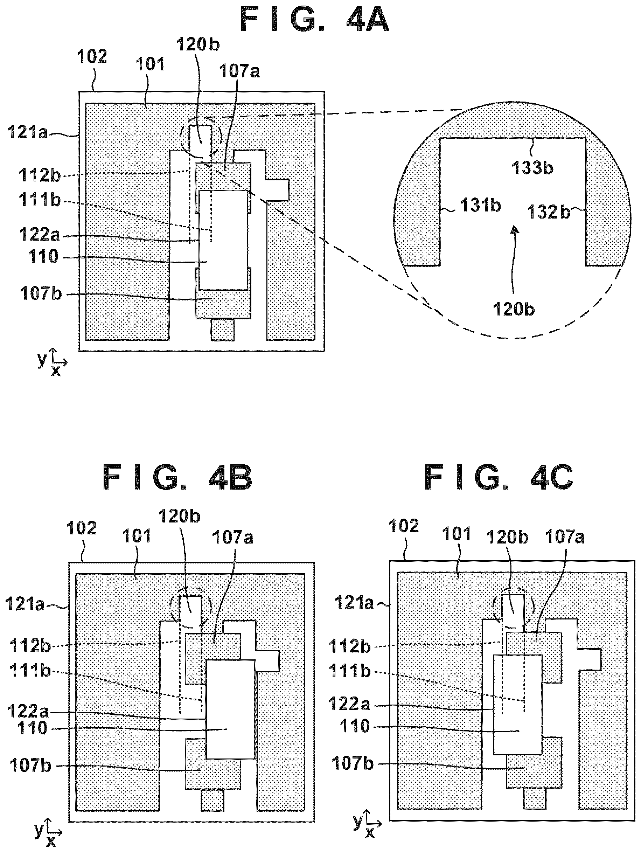

FIGS. 4A to 4C are plan views illustrating a surface of the printed circuit board 100 in which illustration of the resist 101 is omitted. FIG. 4A illustrates an enlarged view of a teaching pattern 120b. The teaching pattern 120b is an electrically conductive pattern formed in the same process as that for the electrically conductive pattern 104. That is, the teaching pattern 120b and the electrode pads 107a and 107b are manufactured in the same process, and so, a positional relationship between the teaching pattern 120b and the electrode pads 107a and 107b is accurate. The teaching pattern 120b has a concave shape constituted by two parallel lines 131b and 132b and a line 133b. The line 133b connects the two lines 131b and 132b. Two imaginary lines 112b and 111b are lines illustrated for descriptive convenience and are imaginary lines obtained by extending each of the two lines 131b and 132b. The two lines 131b and 132b and the two imaginary lines 112b and 111b are parallel to the first side surface 122a of the electronic component 110.

The two lines 131b and 132b and the two imaginary lines 112b and 111b indicate a mountable range of the electronic component 110 in the x direction. The line 131b and the imaginary line 112b indicate an upper limit position in the mountable range of the electronic component 110. The line 132b and the imaginary line 111b indicate a lower limit position in the mountable range of the electronic component 110.

According to FIG. 4A, the first side surface 122a of the electronic component 110 is positioned between the two lines 131b and 132b (two imaginary lines 112b and 111b) constituting the teaching pattern 120b. Therefore, it can be seen that the electronic component 110 is accurately arranged relative to the printed circuit board 100.

According to FIG. 4B, the electronic component 110 is arranged so as to be shifted in a +x direction. The first side surface 122a of the electronic component 110 is not positioned between the two lines 131b and 132b (two imaginary lines 112b and 111b) constituting the teaching pattern 120b. Therefore, it can be seen that the electronic component 110 is not accurately arranged relative to the printed circuit board 100.

According to FIG. 4C, the electronic component 110 is arranged so as to be shifted in a -x direction. The first side surface 122a of the electronic component 110 is not positioned between the two lines 131b and 132b (two imaginary lines 112b and 111b) constituting the teaching pattern 120b. Therefore, it can be seen that the electronic component 110 is not accurately arranged relative to the printed circuit board 100.

### (3-3) Teaching Pattern for Positioning Two Side Surfaces of Electronic Component

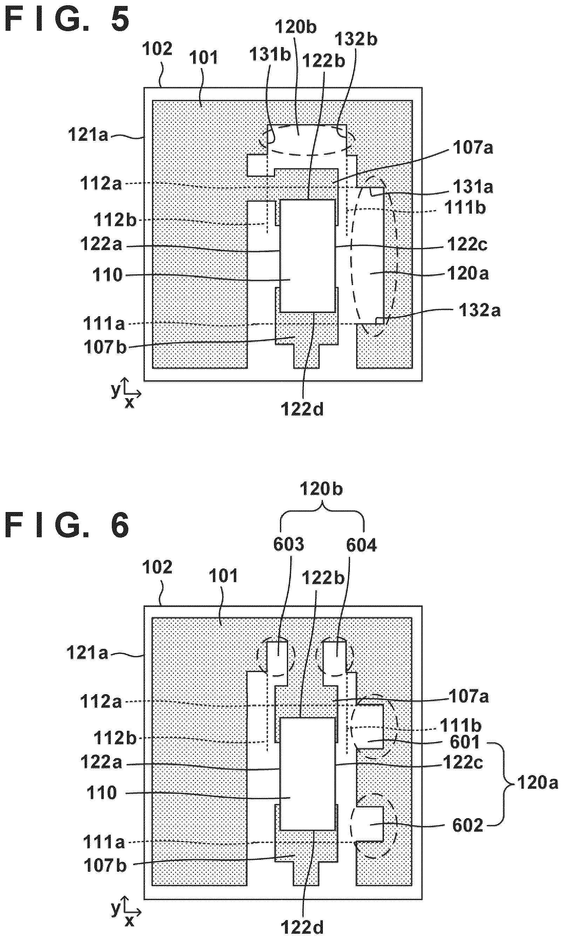

FIG. 5 illustrates another example of the teaching patterns 120a and 120b. The electronic component 110 is arranged such that the second side surface 122b and the fourth side surface 122d of the electronic component 110 are positioned between the two lines 131a and 132a (two imaginary lines 112a and 111a) constituting the teaching pattern 120a. Similarly, the electronic component 110 is arranged such that the first side surface 122a and the third side surface 122c of the electronic component 110 are positioned between the two lines 131b and 132b (two imaginary lines 112b and 111b) constituting the teaching pattern 120b. As described above, a single teaching pattern 120a may indicate a mountable range of two side surfaces of the electronic component 110. In this case, a distance between the two lines 131a and 132a constituting the teaching pattern 120a is longer than a length of the first side surface 122a and longer than a length of the third side surface 122c.

Similarly, a single teaching pattern 120b may indicate a mountable range of two side surfaces of the electronic component 110. In this case, a distance between the two lines 131b and 132b constituting the teaching pattern 120b is longer than a length of the second side surface 122b and longer than a length of the fourth side surface 122d.

As described above, by the electronic component 110 being arranged inside the teaching pattern 120a, the electronic component 110 is accurately positioned in the y direction. By the electronic component 110 being arranged inside the teaching pattern 120b, the electronic component 110 is accurately positioned in the x direction.

### (3-4) Another Example of Teaching Patterns

FIG. 6 illustrates realizing the teaching pattern 120a using two teaching patterns 601 and 602 and realizing the teaching pattern 120b using two teaching patterns 603 and 604. According to FIG. 6, the teaching pattern 601 teaches a mountable range of the second side surface 122b of the electronic component 110. The teaching pattern 602 teaches a mountable range of the fourth side surface 122d of the electronic component 110. The teaching pattern 603 teaches a mountable range of the first side surface 122a of the electronic component 110. The teaching pattern 604 teaches a mountable range of the third side surface 122c of the electronic component 110.

As described above, the teaching patterns 120a and 120b formed in the same process as that for the electrode pads 107a and 107b are employed. Thus, in the first embodiment, it is possible to accurately position the electronic component 110 relative to the electrode pads 107a and 107b as compared to the case of the silkscreen markings 108a to 108d. Instead of the silkscreen markings 108a to 108d, an electrically conductive pattern constituted by the same shapes (e.g., L shapes) as those of the silkscreen markings 108a to 108d may be employed as a teaching pattern.

### <Second Embodiment>

### (1) Teaching Pattern Using Convex Shape

In the first embodiment, the shapes of the teaching patterns 120a and 120b are both concave shapes. However, the shapes of the teaching patterns 120a and 120b may be other shapes so long as they can teach a mounting position of the electronic component 110. Therefore, in the second embodiment, a convex shape will be introduced as the shapes of the teaching patterns 120a and 120b. In the second embodiment, description of matters that are the same as or similar to those of the first embodiment will be omitted, and the description of the first embodiment is incorporated.

### (2) Alignment in y Direction

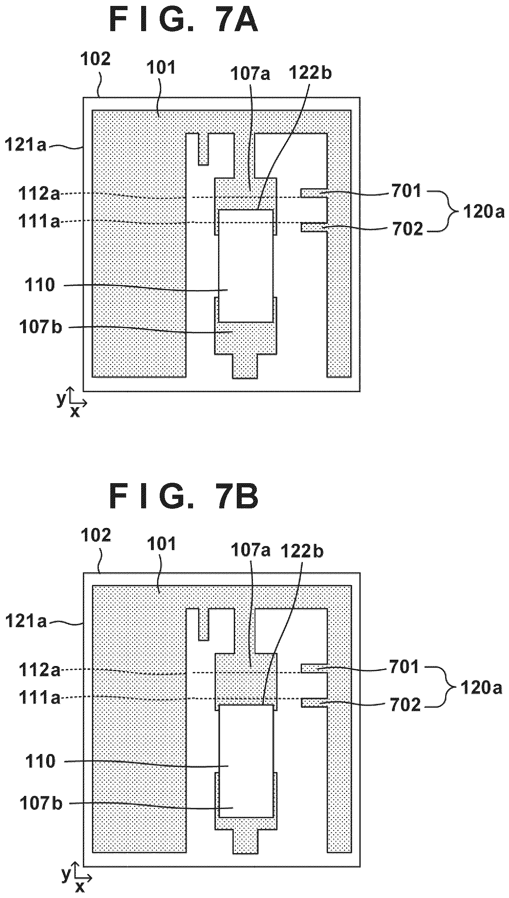

FIGS. 7A to 7C are plan views illustrating a surface of the printed circuit board 100 in which illustration of the resist 101 is omitted. The teaching pattern 120a includes two convex shapes (first convex shape 701 and second convex shape 702) protruding in the -x direction. The two convex shapes teach a mountable range of the second side surface 122b of the electronic component 110 in the y direction. That is, the two imaginary lines 112a and 111a indicating a space between the two convex shapes indicate the mountable range of the second side surface 122b in the y direction. The two convex shapes may be referred to as protrusions. The two imaginary lines 112a and 111a are parallel to the second side surface 122b. The two imaginary lines 112a and 111a are orthogonal to the y direction. Similarly, the second side surface 122b is orthogonal to the y direction.

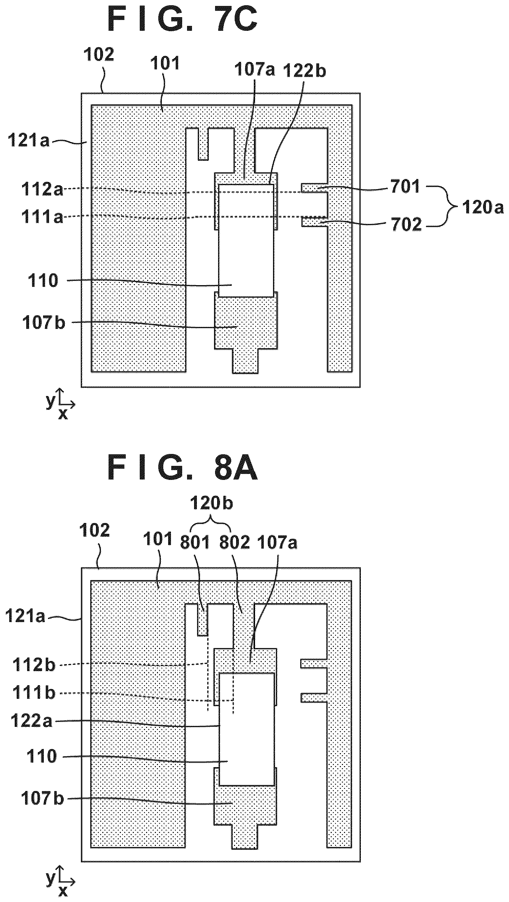

According to FIG. 7A, the second side surface 122b of the electronic component 110 is arranged between the two imaginary lines 111a and 112a extending in the -x direction from the two convex shapes forming the teaching pattern 120a. Therefore, the electronic component 110 is correctly mounted in the y direction. In FIG. 7B, the second side surface 122b of the electronic component 110 is arranged so as to be shifted in the -y direction relative to the teaching pattern 120a. Therefore, the electronic component 110 is not correctly mounted in the y direction. In FIG. 7C, the second side surface 122b of the electronic component 110 is arranged so as to be shifted in the +y direction relative to the teaching pattern 120a. Therefore, the electronic component 110 is not correctly mounted in the y direction. Thus, even if the teaching pattern 120a is realized using two convex shapes, the mounting position of the electronic component 110 in the y direction can be visually confirmed.

### (2) Alignment in x Direction

FIGS. 8A to 8C are plan views illustrating a surface of the printed circuit board 100 in which illustration of the resist 101 is omitted. The teaching pattern 120b includes two convex shapes (first convex shape 801 and second convex shape 802) protruding in the -y direction. The two convex shapes teach a mountable range of the first side surface 122a of the electronic component 110 in the x direction.

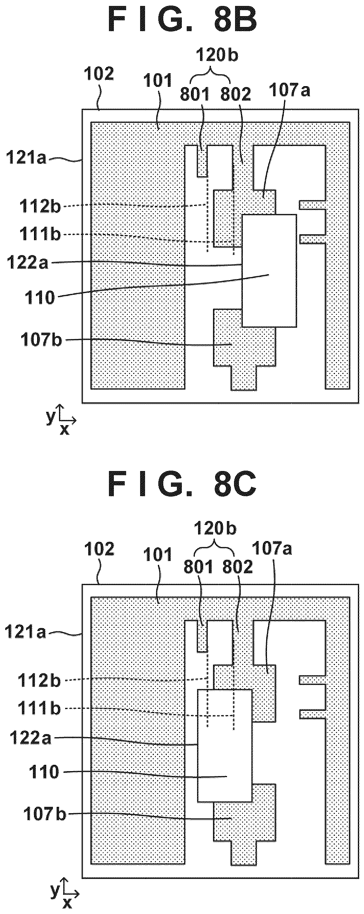

According to FIG. 8A, the first side surface 122a of the electronic component 110 is arranged between the two imaginary lines 111b and 112b extending in the -y direction from the two convex shapes forming the teaching pattern 120b. Therefore, the electronic component 110 is correctly mounted in the x direction. In FIG. 8B, the first side surface 122a of the electronic component 110 is arranged so as to be shifted in the +x direction relative to the teaching pattern 120b. Therefore, the electronic component 110 is not correctly mounted in the x direction. In FIG. 8C, the first side surface 122a of the electronic component 110 is arranged so as to be shifted in the -x direction relative to the teaching pattern 120b. Therefore, the electronic component 110 is not correctly mounted in the x direction. Thus, even if the teaching pattern 120b is realized using two convex shapes, the mounting position of the electronic component 110 in the x direction can be visually confirmed.

Similarly to the first embodiment, in the second embodiment, the teaching patterns 120a and 120b formed in the same process as that for the electrode pads 107a and 107b are employed. Thus, in the second embodiment, it is possible to accurately position the electronic component 110 relative to the electrode pads 107a and 107b as compared to the case of the silkscreen markings 108a to 108d.

A method of confirming whether the electronic component 110 is mounted in a correct position may be visual observation by a human or image processing in which a camera is used. Distances between the teaching patterns 120a and 120b and the electronic component 110 are set to be short (e.g., 10 mm or less). However, the distances are arbitrary so long as the mounting position of the electronic component 110 can be identified through the teaching patterns 120a and 120b.

### <Third Embodiment>

In the second embodiment, the teaching patterns 120a and 120b are each realized using two convex shapes, but this is only one example. In the third embodiment, other shapes of the teaching patterns 120a and 120b will be introduced.

### (1) Teaching Pattern Formed Using Single Convex Shape

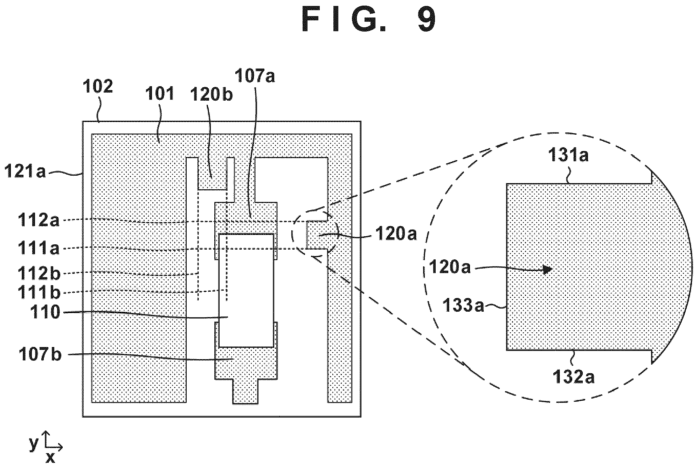

FIG. 9 is a plan view illustrating a surface of the printed circuit board 100 in which illustration of the resist 101 is omitted. The teaching patterns 120a and 120b are each realized by a single convex shape. Thus, extension lines of two outer edges forming a convex shape may form two imaginary lines (pair of imaginary lines 111a and 112a and pair of imaginary line 111b and 112b).

### (2) Other Examples of Concave and Convex Shapes

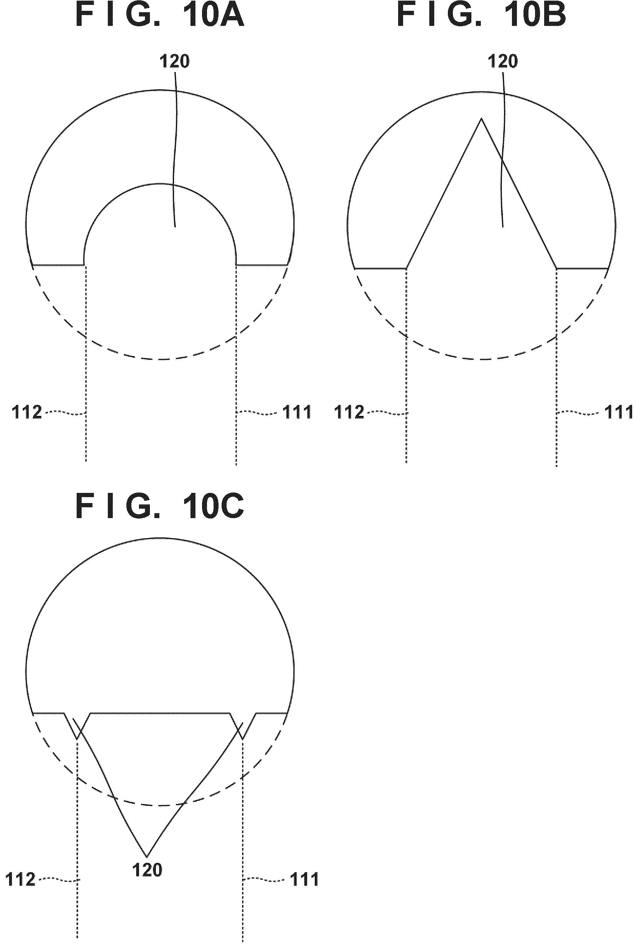

FIGS. 10A to 10C are enlarged views of the teaching patterns 120a and 120b. In FIG. 10A, the teaching patterns 120a and 120b are denoted as the teaching pattern 120. The imaginary lines 111a, 112a, 111b, and 112b are denoted as imaginary lines 111 and 112. In the first embodiment, the recesses of the teaching patterns 120a and 120b are rectangles. However, the shapes of the recesses may be semicircular. As illustrated in FIG. 10B, the recesses of the teaching patterns 120a and 120b may be triangles. The recesses may be semicircles or the like.

In FIGS. 7A and 8A, the teaching patterns 120a and 120b are each formed using two convex shapes. The two convex shapes are rectangles. As illustrated in FIG. 10C, the two convex shapes may be triangles. In this case, the two imaginary lines 111 and 112 extend in the y direction or the x direction from vertices of the triangles.

As described above, it is sufficient so long as the shapes of the teaching patterns 120a and 120b make it possible to conceptualize the two imaginary lines 111 and 112 defining a mountable range of the electronic component 110.

In the first to third embodiments, a combination of the shape of the teaching pattern 120a and the shape of the teaching pattern 120b are a pair of a convex shape and a convex shape or a pair of a concave shape and a concave shape. However, these are only examples. A configuration may be taken such that the shape of the teaching pattern 120a is a convex shape and the shape of the teaching pattern 120b is a concave shape. To the contrary, a configuration may be taken such that the shape of the teaching pattern 120a is a concave shape and the shape of the teaching pattern 120b is a convex shape. A case of the convex shape and a case of the concave shape may be any shape suggested in the first to third embodiments.

### <Fourth Embodiment>

In the fourth embodiment, some cases where the printed circuit board 100 described in the first to third embodiments can be applied will be introduced.

### (1) Optical Sensor

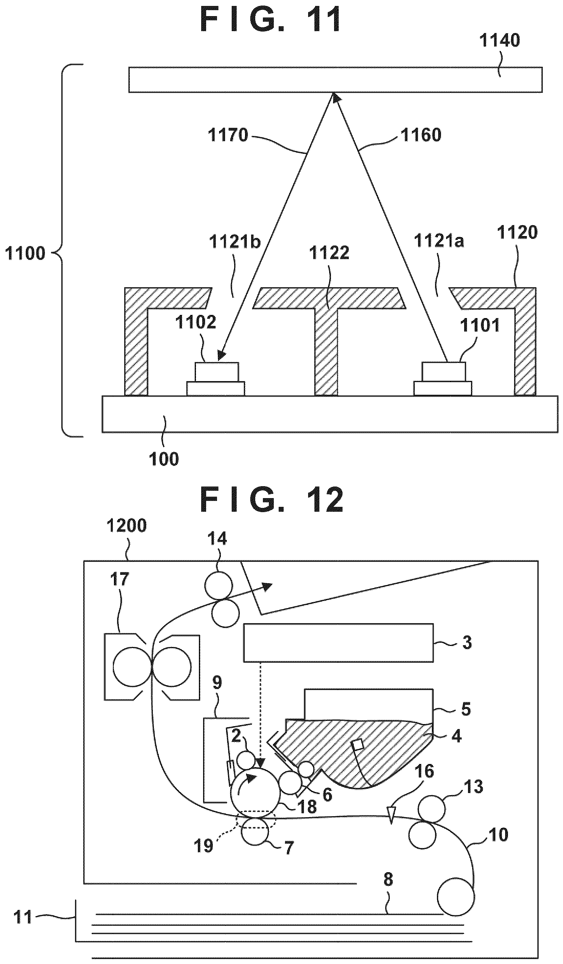

FIG. 11 illustrates an optical sensor 1100. An LED 1101, which is a chip-type light emitting element, and a chip-type PD 1102, which is a light receiving element, are mounted on the mounting surface of the printed circuit board 100. LED is an abbreviation for Light Emitting Diode. PD is an abbreviation for Photo Diode.

An aperture 1120 is further provided on the mounting surface of the printed circuit board 100. The aperture 1120 is an optical diaphragm. The aperture 1120 includes openings 1121a and 1121b and a light-shielding wall 1122. The light-shielding wall 1122 is provided so as to surround each of the LED 1101 and the PD 1102, thereby preventing light from the LED 1101 from directly entering the PD 1102.

The opening 1121a is an opening for allowing light outputted from the LED 1101 to pass through. The opening 1121b is an opening for allowing light coming in from the outside to pass through. The aperture 1120 acts to narrow the light outputted from the LED 1101 and the light coming in from the outside. With this, a light receiving performance of the optical sensor 1100 is improved.

A reflecting plate 1140 is arranged so as to face the printed circuit board 100. The light outputted from the LED 1101 irradiates the reflecting plate 1140 along an optical path 1160. That light is reflected by the reflecting plate 1140, and the reflected light enters the PD 1102 along an optical path 1170. The PD 1102 outputs a signal corresponding to received light. When light is blocked by some object, such as a sheet, the level of the signal outputted from the PD 1102 changes. Thus, the optical sensor 1100 can be used as a sensor for detecting a presence of an object. In addition, the PD 1102 detects light reflected off of an object and outputs a signal corresponding to a surface property of the object. Thus, the optical sensor 1100 can be used as a sensor for detecting a surface property (e.g., roughness of a surface of a sheet, presence or absence of coating, etc.) or a type (e.g., grammage) of an object.

### (2) Image Forming Apparatus

FIG. 12 illustrates an electrophotographic image forming apparatus 1200. A photosensitive drum 18 is an image carrying member that includes a photosensitive layer such as an organic photoconductor. The photosensitive drum 18 rotates in an arrow direction at a predetermined processing speed. A charging roller 2 charges the surface of the photosensitive drum 18 such that the potential on the surface of the photosensitive drum 18 becomes a predetermined potential. A laser beam scanner 3 exposes the surface of the photosensitive drum 18 by outputting a laser beam according to an image signal and thereby forms an electrostatic latent image.

A developer container 5 houses toner 4. A developer carrying member 6 develops an electrostatic latent image using the toner 4 and thereby forms a toner image. The developer carrying member 6 may be referred to as a developing roller or a developing sleeve.

By the photosensitive drum 18 rotating, the toner image is conveyed to a transfer unit 19. The transfer unit 19 is constituted by the photosensitive drum 18 and a transfer roller 7. A sheet cassette 11 is a housing case for housing a large number of sheets 8. A feeding roller 12 feeds one sheet 8 from the sheet cassette 11 to a conveyance path 10. Conveyance rollers 13 convey the sheet 8 to the transfer unit 19 along the conveyance path 10. A sheet sensor 16 is arranged on a downstream side of the conveyance rollers 13. The sheet sensor 16 is realized by the optical sensor 1100. The laser beam scanner 3 outputs a laser beam based on a timing at which the sheet sensor 16 detects a front end of the sheet 8. Thus, a timing at which the toner image arrives at the transfer unit 19 is synchronized with a timing at which the sheet 8 arrives.

The transfer unit 19 transfers the toner image from the photosensitive drum 18 to the sheet 8. A cleaning container 9 collects the toner 4 remaining on the photosensitive drum 18. The photosensitive drum 18, the charging roller 2, the developer container 5, and the cleaning container 9 are provided in an integrated manner and may be referred to as a process cartridge.

The sheet 8 is conveyed from the transfer unit 19 to a fixing device 17. By the fixing device 17 applying heat and pressure to the toner image and the sheet 8, the toner image is fixed onto the sheet 8. Discharge rollers 14 discharge the sheet 8 to the outside of the image forming apparatus 1200. The toner 4 is fixed onto the sheet 8 while being heated and pressed by the fixing device 17. With this, a printed matter constituted by the sheet 8 and the toner image may be subjected to an antibacterial treatment.

In FIG. 12, the image forming apparatus 1200 which forms a monochrome image is illustrated, but technical concepts of the present invention is also applicable to an image forming apparatus that forms a full color image. Further, the sheet 8 may be preprinted paper on which printing has already been performed.

The optical sensor 1100 mounted in the image forming apparatus 1200 as the sheet sensor 16 irradiates light from the LED 1101 mounted on the printed circuit board 100 to the reflecting plate 1140 and receives light reflected off of the reflecting plate 1140 using the PD 1102. In such an optical sensor 1100, by mounting positions of the LED 1101 and the PD 1102, which are chip-type electronic components, being shifted, the amount of received light may decrease, or a detection accuracy of a sheet P or a surface property may decrease.

Therefore, the teaching pattern 120, which is an electronically conductive pattern described in the first to third embodiments, is employed. Thus, the mounting positions of the LED 1101 and the PD 1102 are each accurate as compared to the case of silk-screen-printed markings (silkscreen markings 108a to 108d), and thereby, the detection accuracy is improved. Further, since stray light caused by a silkscreen reflecting light is reduced, the detection accuracy of the optical sensor 1100 is improved. Since a position of a sheet P can be accurately ascertained, the image forming apparatus 1200 may be able to form a toner image at an accurate position on the sheet P. The sheet sensor 16 may be used as a media sensor for detecting a surface property, a type (e.g., cardboard, thin paper, plain paper, coated paper), or the like of a sheet S. In this case, the image forming apparatus 1200 may be able to accurately control a density of a toner image or a fixing temperature of the fixing device 17 based on a detection result of the sheet sensor 16.

### <Technical Concepts Derived from Embodiments>

(Item 1) A printed circuit board (100) characterized by comprising:
a substrate (102); and
an electrically conductive pattern (104) arranged on the substrate,
the electrically conductive pattern (104) including:
   an electrode pad (107a) on which an electronic component (110) is to be mounted, and
   a first teaching pattern (120a; 120b) that teaches a mountable range of the electronic component and includes a first line (131a; 131b) and a second line (132a; 132b),
   wherein
   when viewed from a direction orthogonal to a mounting surface of the printed circuit board (100), the electronic component (110) includes a first side surface (122a; 122b; 122c; 122d) extending in a first direction, which is a direction along the mounting surface,
   the first line (131a; 131b) and the second line (132a; 132b) extend in the first direction,
   in a second direction orthogonal to the first direction and a direction of a normal of the mounting surface, the first side surface (122a; 122b; 122c; 122d) is between the first line (131a; 131b) and the second line (132a; 132b), and
   in the first direction, a position of the first line (131a; 131b) is different from a position of the first side surface (122a; 122b; 122c; 122d), and a position of the second line (132a; 132b) is different from the position of the first side surface (122a; 122b; 122c; 122d).

As described in the first to the third embodiments, the teaching patterns 120a and 120b are formed either near the electrode pad 107a or near the electrode pad 107b and have predetermined shapes for teaching a mountable range of the electronic component 110 relative to the electrode pads 107a and 107b. With this, it becomes easier to confirm that the electronic component 110 is correctly mounted at a predetermined position.

According to FIGS. 3A, 4A, 5, 6, 7A, 8A, 9, and 10A to 10C, the lines 131a, 131b, 132a, and 132b and the imaginary lines 111 and 112 are illustrated. The lines 131a, 131b, 132a, and 132b and the imaginary lines 111 and 112 are examples of at least two lines (first line and second line) that teach the mountable range of the electronic component 110. Thus, the at least two lines are useful for visually teaching a mountable range of an electronic component.

When viewed in a direction (e.g., -z direction) orthogonal to a mounting surface of a printed circuit board, the electronic component may include a first side surface extending in a first direction (e.g., x direction or y direction), which is a direction along the mounting surface. Here, the first line and the second line extend in the first direction. There is a second direction (e.g., y direction or x direction) orthogonal to the first direction and orthogonal to a direction of a normal of the mounting surface. In the second direction, the first side surface may be between the first line and the second line. Further, in the first direction, the first line and the second line may each be at a position different from that of the first side surface. In the second direction, the first line and the second line may each be at a position different from that of the first side surface.

The lines 131a and 131b and the imaginary line 112 are examples of the first line, which indicates a first limit position (upper limit position). The lines 132a and 132b and the imaginary line 111 are examples of the second line, which indicates a second limit position (lower limit position).

(Item 2) The printed circuit board according to Item 1, wherein
the first line and the second line are each on the same side relative to the electronic component, in the first direction.

As illustrated in FIG. 3A and the like, the first line and the second line may each be on the same side relative to the electronic component in the first direction.

(Item 3) The printed circuit board according to Item 2, wherein
the printed circuit board includes a first side, and
the first line is a line parallel to a direction orthogonal to the first side.

For example, the line 131a and the imaginary line 112a are lines parallel to the x direction, which is orthogonal to the first side 121a.

(Item 4) The printed circuit board according to Item 3, wherein
the second line is a line parallel to the direction orthogonal to the first side.

For example, the line 132a and the imaginary line 111a are lines parallel to the x direction, which is orthogonal to the first side 121a.

(Item 5) The printed circuit board according to any one of Items 1-4, wherein
the first teaching pattern includes a shape that is recessed in a direction from a first side of the printed circuit board toward the electrode pad.

As illustrated in FIG. 3A, the teaching pattern 120a includes a shape recessed in a direction from a side 121a toward the electrode pad 107a of the printed circuit board 100.

(Item 6) The printed circuit board according to Item 5, wherein
the shape that is recessed includes:
the first line and the second line, and
a third line that connects the first line and the second line and is parallel to the first side,
the first line indicates an upper limit position in a direction parallel to the first side of the printed circuit board, in the mountable range of the electronic component, and
the second line indicates a lower limit position in the direction parallel to the first side of the printed circuit board, in the mountable range of the electronic component.

As illustrated in FIG. 3A, the lines 131a and 132a are examples of the first line and the second line. The line 133a is one example of a third line. The line 131a may indicate an upper limit position in a direction parallel to the first side of the printed circuit board, in the mountable range of the electronic component. The line 132a may indicate a lower limit position in a direction parallel to the first side of the printed circuit board, in the mountable range of the electronic component.

(Item 7) The printed circuit board according to any one of Items 1-4, wherein
the first teaching pattern includes a shape that protrudes in a direction from the electrode pad toward a first side of the printed circuit board.

As illustrated in FIGS. 7A and 9 and the like, the teaching pattern 120a may include a shape protruding in the -x direction.

(Item 8) The printed circuit board according to Item 7, wherein
the shape that protrudes includes:
the first line and the second line that are orthogonal to the first side, and
a third line that connects the first line and the second line and is parallel to the first side,
the first line indicates an upper limit position in a direction parallel to the first side of the printed circuit board, in the mountable range of the electronic component, and
the second line indicates a lower limit position in the direction parallel to the first side of the printed circuit board, in the mountable range of the electronic component.

As illustrated in FIG. 9, a convex-shaped teaching pattern 120a includes the first line 131a, the second line 132a and the third line 133a. The first line 131a and the second line 132a indicate limit positions of the mountable range of the electronic component 110.

(Item 9) The printed circuit board according to any one of Items 1-4, wherein
the first teaching pattern includes at least two convex shapes that protrude in a direction from the electrode pad toward a first side of the printed circuit board.

As illustrated in FIG. 7A, the teaching pattern 120a includes two convex shapes protruding in the -x direction.

(Item 10) The printed circuit board according to Item 9, wherein
the at least two convex shapes include a first convex shape and a second convex shape,
the first convex shape indicates an upper limit position in a direction parallel to the first side of the printed circuit board, in the mountable range of the electronic component, and
the second convex shape indicates a lower limit position in the direction parallel to the first side of the printed circuit board, in the mountable range of the electronic component.

As illustrated in FIG. 7A, the teaching pattern 120a may include the first convex shape 701 and the second convex shape 702. The first convex shape 701 indicates an upper limit position of the mountable range of the electronic component. The second convex shape 702 indicates a lower limit position of the mountable range of the electronic component. As illustrated in FIG. 8A, the teaching pattern 120b may include the first convex shape 801 and the second convex shape 802. The first convex shape 801 and the second convex shape 802 may indicate the upper limit position and the lower limit position, respectively.

As illustrated in FIG. 1 and the like, the electronic component 110 includes the four side surfaces 122a to 122d in a plan view. When the electronic component 110 is of a BGA type, a ball grid is arranged on a bottom side of the electronic component 110. A model number of the electronic component 110 and the like are printed or engraved on an upper surface of the electronic component 110.

(Item 11) The printed circuit board according to any one of Items 1-10, wherein
the electronic component includes a second side surface, a third side surface, and a fourth side surface,
the first side surface and the third side surface are parallel,
the second side surface and the fourth side surface are parallel, and
the mountable range of the electronic component is a range that the first side surface and the third side surface of the printed circuit board may take, when the printed circuit board is viewed in a plan view.

As illustrated in FIG. 5, the mountable range of the electronic component 110 taught by the teaching pattern 120a may be a range that the side surface 122b and the side surface 122d of the electronic component 110 may take. Further, the mountable range of the electronic component 110 taught by the teaching pattern 120b may be a range that the side surface 122a and the side surface 122c of the electronic component 110 may take.

(Item 12) The printed circuit board according to any one of Items 1-11, wherein
the electrically conductive pattern further includes:
a second teaching pattern including a predetermined shape for teaching the mountable range of the electronic component relative to the electrode pad,
the first teaching pattern teaches the mountable range of the electronic component in a direction parallel to a first side of the printed circuit board, and
the second teaching pattern teaches the mountable range of the electronic component in a direction orthogonal to the first side of the printed circuit board.

The teaching pattern 120a indicates the mountable range of the electronic component 110 in the y direction. The teaching pattern 120b indicates the mountable range of the electronic component 110 in the x direction. With this, it may be easy to confirm that the electronic component 110 is arranged at an accurate position not only in the y direction but also in the x direction.

(Item 13) The printed circuit board according to Item 12, wherein
the first teaching pattern includes a shape that protrudes in a direction from the electrode pad toward the first side of the printed circuit board, and
the second teaching pattern includes a shape that protrudes in a direction from a second side orthogonal to the first side of the printed circuit board toward the electrode pad.

As illustrated in FIGS. 7A and 9, the teaching pattern 120a may include a shape protruding in the -x direction. As illustrated in FIGS. 8A and 9, the teaching pattern 120b may include a shape protruding in the -y direction.

(Item 14) The printed circuit board according to Item 12, wherein
the first teaching pattern includes a shape that is recessed in a direction from the first side of the printed circuit board toward the electrode pad.
the second teaching pattern includes a shape that protrudes in a direction from a second side orthogonal to the first side of the printed circuit board toward the electrode pad.

As illustrated in FIG. 3A, the teaching pattern 120a includes a shape recessed in the x direction. As illustrated in FIGS. 8A and 9, the teaching pattern 120b may include a shape protruding in the -y direction. Thus, the teaching pattern 120a having a concave shape and the teaching pattern 120b having a convex shape may be combined.

(Item 15) The printed circuit board according to Item 12, wherein
the first teaching pattern includes a shape that is recessed in a direction from the first side of the printed circuit board toward the electrode pad, and
the second teaching pattern includes a shape that is recessed in a direction from a second side orthogonal to the first side of the printed circuit board toward the electrode pad.

As illustrated in FIG. 3A, the teaching pattern 120a may include a shape recessed in the +x direction. As illustrated in FIG. 4A, the teaching pattern 120b may include a shape recessed in the +y direction.

(Item 16) The printed circuit board according to Item 12, wherein
the first teaching pattern includes a shape that protrudes in a direction from the electrode pad toward the first side of the printed circuit board, and
the second teaching pattern includes a shape that is recessed in a direction from a second side orthogonal to the first side of the printed circuit board toward the electrode pad.

As illustrated in FIGS. 7A and 9, the teaching pattern 120a may include a shape protruding in the -x direction. As illustrated in FIG. 4A, the teaching pattern 120b may include a shape recessed in the +y direction. Thus, the teaching pattern 120a having a convex shape and the teaching pattern 120b having a concave shape may be combined.

(Item 17) The printed circuit board according to any one of Items 1-11, wherein
the electronic component includes a second side surface, a third side surface, and a fourth side surface,
the first side surface and the third side surface are parallel,
the second side surface and the fourth side surface are parallel, and
the electrically conductive pattern further includes a second teaching pattern,
the first teaching pattern indicates for the first side surface the mountable range of the electronic component, and
the second teaching pattern indicates for the third side surface the mountable range of the electronic component.

As illustrated in FIG. 6, the teaching pattern 601 indicates for the side surface 122b the mountable range of the electronic component 110. The teaching pattern 602 indicates for the side surface 122d the mountable range of the electronic component 110. The teaching pattern 603 indicates for the side surface 122a the mountable range of the electronic component 110. The teaching pattern 604 indicates for the side surface 122c the mountable range of the electronic component 110. In this manner, a plurality of teaching patterns 120 indicating alignment of the electronic component 110 in the y direction may be provided. Similarly, a plurality of teaching patterns 120 indicating alignment of the electronic component 110 in the x direction may be provided.

(Item 18) The printed circuit board according to any one of Items 1-11, wherein
the electronic component includes a second side surface, a third side surface, and a fourth side surface,
the first side surface and the third side surface are parallel,
the second side surface and the fourth side surface are parallel, and
the electrically conductive pattern further includes a second teaching pattern,
the first teaching pattern indicates for the first side surface the mountable range of the electronic component, and
the second teaching pattern indicates for the second side surface the mountable range of the electronic component.

As illustrated in FIG. 3A and the like, the teaching pattern 120a indicates for the side surface 122b the mountable range of the electronic component 110. As illustrated in FIG. 4A and the like, the teaching pattern 120b indicates for the side surface 122a the mountable range of the electronic component 110.

(Item 19) An optical sensor (1100) characterized by comprising:
a printed circuit board (100)as specified in Items 1-18, and
the electronic component includes a chip-type light emitting element and a chip-type light receiving element.

As illustrated in FIG. 11, the electronic component 110 may be the LED 1101 or the PD 1102. With this, the mounting position of the LED 1101 or the PD 1102 becomes accurate, and reduction in the amount of light received by the optical sensor 1100 may be suppressed.

(Item 20) An image forming apparatus (1200) characterized by comprising:
conveying means for conveying a sheet along a conveyance path;
detecting means for detecting a timing at which the sheet conveyed by the conveying means passes or detecting a type of the sheet; and
image forming means for forming an image on the sheet, wherein the detecting means includes a printed circuit board (100) as specified in Items 1-18, and
the electronic component includes a chip-type light emitting element and a chip-type light receiving element.

The conveyance rollers 13 are an example of a conveying rotation member. The photosensitive drum 18, the transfer unit 19 and the like are an example of an image forming unit. By employing the optical sensor 1100 as the sheet sensor 16, the image forming apparatus 1200 is controlled with high accuracy. For example, a formation position of a toner image on the sheet 8 may be more accurate. Further, a fixing temperature of the fixing device 17, which is adjusted according to a surface property or a type of the sheet 8 may be more accurately controlled. As a result, a density and a tone property of a toner image to be formed on the sheet 8 may improve.

### Other Embodiments

Embodiment(s) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{™}), a flash memory device, a memory card, and the like.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A printed circuit board (100) **characterized by** comprising:
a substrate (102); and
an electrically conductive pattern (104) arranged on the substrate,
the electrically conductive pattern (104) including:
an electrode pad (107a) on which an electronic component (110) is to be mounted, and
a first teaching pattern (120a; 120b) that teaches a mountable range of the electronic component and includes a first line (131a; 131b) and a second line (132a; 132b),
wherein
when viewed from a direction orthogonal to a mounting surface of the printed circuit board (100), the electronic component (110) includes a first side surface (122a; 122b; 122c; 122d) extending in a first direction, which is a direction along the mounting surface,
the first line (131a; 131b) and the second line (132a; 132b) extend in the first direction,
in a second direction orthogonal to the first direction and a direction of a normal of the mounting surface, the first side surface (122a; 122b; 122c; 122d) is between the first line (131a; 131b) and the second line (132a; 132b), and
in the first direction, a position of the first line (131a; 131b) is different from a position of the first side surface (122a; 122b; 122c; 122d), and a position of the second line (132a; 132b) is different from the position of the first side surface (122a; 122b; 122c; 122d).

2. The printed circuit board according to Claim 1, wherein
the first line and the second line are each on the same side relative to the electronic component, in the first direction.

3. The printed circuit board according to Claim 2, wherein
the printed circuit board includes a first side, and
the first line is a line parallel to a direction orthogonal to the first side.

4. The printed circuit board according to Claim 3, wherein
the second line is a line parallel to the direction orthogonal to the first side.

5. The printed circuit board according to any one of Claims 1-4, wherein
the first teaching pattern includes a shape that is recessed in a direction from a first side of the printed circuit board toward the electrode pad.

6. The printed circuit board according to Claim 5, wherein
the shape that is recessed includes:
the first line and the second line, and
a third line that connects the first line and the second line and is parallel to the first side,
the first line indicates an upper limit position in a direction parallel to the first side of the printed circuit board, in the mountable range of the electronic component, and
the second line indicates a lower limit position in the direction parallel to the first side of the printed circuit board, in the mountable range of the electronic component.

7. The printed circuit board according to any one of Claims 1-4, wherein
the first teaching pattern includes a shape that protrudes in a direction from the electrode pad toward a first side of the printed circuit board.

8. The printed circuit board according to Claim 7, wherein
the shape that protrudes includes:
the first line and the second line that are orthogonal to the first side, and
a third line that connects the first line and the second line and is parallel to the first side,
the first line indicates an upper limit position in a direction parallel to the first side of the printed circuit board, in the mountable range of the electronic component, and
the second line indicates a lower limit position in the direction parallel to the first side of the printed circuit board, in the mountable range of the electronic component.

9. The printed circuit board according to any one of Claims 1-4, wherein
the first teaching pattern includes at least two convex shapes that protrude in a direction from the electrode pad toward a first side of the printed circuit board.

10. The printed circuit board according to Claim 9, wherein
the at least two convex shapes include a first convex shape and a second convex shape,
the first convex shape indicates an upper limit position in a direction parallel to the first side of the printed circuit board, in the mountable range of the electronic component, and
the second convex shape indicates a lower limit position in the direction parallel to the first side of the printed circuit board, in the mountable range of the electronic component.

11. The printed circuit board according to any one of Claims 1-10, wherein
the electronic component includes a second side surface, a third side surface, and a fourth side surface,
the first side surface and the third side surface are parallel,
the second side surface and the fourth side surface are parallel, and
the mountable range of the electronic component is a range that the first side surface and the third side surface of the printed circuit board may take, when the printed circuit board is viewed in a plan view.

12. The printed circuit board according to any one of Claims 1-11, wherein
the electrically conductive pattern further includes:
a second teaching pattern including a predetermined shape for teaching the mountable range of the electronic component relative to the electrode pad,
the first teaching pattern teaches the mountable range of the electronic component in a direction parallel to a first side of the printed circuit board, and
the second teaching pattern teaches the mountable range of the electronic component in a direction orthogonal to the first side of the printed circuit board.

13. The printed circuit board according to Claim 12, wherein
the first teaching pattern includes a shape that protrudes in a direction from the electrode pad toward the first side of the printed circuit board, and
the second teaching pattern includes a shape that protrudes in a direction from a second side orthogonal to the first side of the printed circuit board toward the electrode pad.

14. The printed circuit board according to Claim 12, wherein
the first teaching pattern includes a shape that is recessed in a direction from the first side of the printed circuit board toward the electrode pad, and
the second teaching pattern includes a shape that protrudes in a direction from a second side orthogonal to the first side of the printed circuit board toward the electrode pad.

15. The printed circuit board according to Claim 12, wherein
the first teaching pattern includes a shape that is recessed in a direction from the first side of the printed circuit board toward the electrode pad, and
the second teaching pattern includes a shape that is recessed in a direction from a second side orthogonal to the first side of the printed circuit board toward the electrode pad.

16. The printed circuit board according to Claim 12, wherein
the first teaching pattern includes a shape that protrudes in a direction from the electrode pad toward the first side of the printed circuit board, and
the second teaching pattern includes a shape that is recessed in a direction from a second side orthogonal to the first side of the printed circuit board toward the electrode pad.

17. The printed circuit board according to any one of Claims 1-11, wherein
the electronic component includes a second side surface, a third side surface, and a fourth side surface,
the first side surface and the third side surface are parallel,
the second side surface and the fourth side surface are parallel, and
the electrically conductive pattern further includes a second teaching pattern,
the first teaching pattern indicates for the first side surface the mountable range of the electronic component, and
the second teaching pattern indicates for the third side surface the mountable range of the electronic component.

18. The printed circuit board according to any one of Claims 1-11, wherein
the electronic component includes a second side surface, a third side surface, and a fourth side surface,
the first side surface and the third side surface are parallel,
the second side surface and the fourth side surface are parallel, and the electrically conductive pattern further includes a second teaching pattern,
the first teaching pattern indicates for the first side surface the mountable range of the electronic component, and
the second teaching pattern indicates for the second side surface the mountable range of the electronic component.

19. An optical sensor (1100) **characterized by** comprising:
a printed circuit board (100), the printed circuit board (100) including:
a substrate (102); and
an electrically conductive pattern (104) arranged on the substrate,
the electrically conductive pattern (104) including:
an electrode pad (107a) on which an electronic component (110) is to be mounted, and
a first teaching pattern (120a; 120b) that teaches a mountable range of the electronic component and includes a first line (131a; 131b) and a second line (132a; 132b),
wherein
when viewed from a direction orthogonal to a mounting surface of the printed circuit board (100), the electronic component (110) includes a first side surface (122a; 122b; 122c; 122d) extending in a first direction, which is a direction along the mounting surface,
the first line (131a; 13 1b) and the second line (132a; 132b) extend in the first direction,
in a second direction orthogonal to the first direction and a direction of a normal of the mounting surface, the first side surface (122a; 122b; 122c; 122d) is between the first line (131a; 131b) and the second line (132a; 132b), and
in the first direction, a position of the first line (122a; 122b; 122c; 122d) is different from a position of the first side surface (122a; 122b; 122c; 122d), and a position of the second line (132a; 132b) is different from the position of the first side surface (122a; 122b; 122c; 122d), and
the electronic component includes a chip-type light emitting element and a chip-type light receiving element.

20. An image forming apparatus (1200) **characterized by** comprising:
conveying means for conveying a sheet along a conveyance path;
detecting means for detecting a timing at which the sheet conveyed by the conveying means passes or detecting a type of the sheet; and
image forming means for forming an image on the sheet, wherein the detecting means includes a printed circuit board (100), the printed circuit board (100) including:
a substrate (102); and
an electrically conductive pattern (104) arranged on the substrate,
the electrically conductive pattern (104) including:
an electrode pad (107a) on which an electronic component (110) is to be mounted, and
a first teaching pattern (120a; 120b) that teaches a mountable range of the electronic component and includes a first line (131a; 131b) and a second line (132a; 132b),
wherein
when viewed from a direction orthogonal to a mounting surface of the printed circuit board (100), the electronic component (110) includes a first side surface (122a; 122b; 122c; 122d) extending in a first direction, which is a direction along the mounting surface,
the first line (131a; 131b) and the second line (132a; 132b) extend in the first direction,
in a second direction orthogonal to the first direction and a direction of a normal of the mounting surface, the first side surface (122a; 122b; 122c; 122d) is between the first line (131a; 131b) and the second line (132a; 132b), and
in the first direction, a position of the first line (122a; 122b; 122c; 122d) is different from a position of the first side surface (122a; 122b; 122c; 122d), and a position of the second line (132a; 132b) is different from the position of the first side surface (122a; 122b; 122c; 122d), and
the electronic component includes a chip-type light emitting element and a chip-type light receiving element.
